(19) Europäisches Patentamt
European Patent Office
Office européen des brevets

(11) **EP 1 313 895 B1**

(12) **EUROPÄISCHE PATENTSCHRIFT**

(45) Veröffentlichungstag und Bekanntmachung des Hinweises auf die Patenterteilung:
**30.05.2007   Patentblatt 2007/22**

(21) Anmeldenummer: **00967543.0**

(22) Anmeldetag: **29.08.2000**

(51) Int Cl.:
*C25D 7/00* (2006.01)   *H01L 39/24* (2006.01)
*C25D 5/54* (2006.01)   *C25D 5/00* (2006.01)
*C25D 5/20* (2006.01)   *C25D 5/50* (2006.01)

(86) Internationale Anmeldenummer:
**PCT/DE2000/002966**

(87) Internationale Veröffentlichungsnummer:
**WO 2002/016674 (28.02.2002 Gazette 2002/09)**

(54) **VERFAHREN ZUR METALLISCHEN BESCHICHTUNG DER OBERFLÄCHE VON HOCHTEMPERATUR-SUPRALEITERN**

METHOD FOR METAL COATING THE SURFACE OF HIGH TEMPERATURE SUPERCONDUCTORS

PROCEDE DE METALLISATION SUPERFICIELLE DE SUPRACONDUCTEURS A HAUTE TEMPERATURE

(84) Benannte Vertragsstaaten:
**CH ES FR GB IT LI**

(30) Priorität: **19.08.2000  DE 10040935**

(43) Veröffentlichungstag der Anmeldung:
**28.05.2003   Patentblatt 2003/22**

(73) Patentinhaber: **Adelwitz Technologiezentrum GmbH**
**04886 Adelwitz (DE)**

(72) Erfinder:
• **WERFEL, Frank**
**04277 Leipzig (DE)**
• **FLÖGEL-DELOR, Uta**
**04860 Losswig (DE)**
• **ROTHFELD, Rolf**
**04838 Mockrehna (DE)**
• **WIPPICH, Dieter**
**04886 Beilrode (DE)**

(74) Vertreter: **Lang, Friedrich et al**
**Lang & Tomerius**
**Postfach 15 13 24**
**80048 München (DE)**

(56) Entgegenhaltungen:
EP-A- 0 328 651          DE-A- 19 939 144
DE-C- 4 018 870          US-A- 4 914 081

• **PATENT ABSTRACTS OF JAPAN vol. 017, no. 458 (C-1100), 20. August 1993 (1993-08-20) -& JP 05 106080 A (ISUZU MOTORS LTD), 27. April 1993 (1993-04-27) -& DATABASE WPI Derwent Publications Ltd., London, GB; AN 1993-172960 XP002170000**
• **ROSAMILIA J M ET AL: "ELECTRODEPOSITION OF METALS ON CUPRATE SUPERCONDUCTORS FROM ORGANIC ELECTROLYTES" EXTENDED ABSTRACTS,US, ELECTROCHEMICAL SOCIETY. PRINCETON, NEW JERSEY, Bd. 89 / 2, 1989, Seite 370 XP000277062 ISSN: 0160-4619**
• **DATABASE WPI Section Ch, Week 199649 Derwent Publications Ltd., London, GB; Class L03, AN 1996-496201 XP002169983 & RU 2 055 946 C (TOMSK POLY NUCL PHYS RES INST), 10. März 1996 (1996-03-10)**

Bemerkungen:
Die Akte enthält technische Angaben, die nach dem Eingang der Anmeldung eingereicht wurden und die nicht in dieser Patentschrift enthalten sind.

EP 1 313 895 B1

## Beschreibung

Die Erfindung betrifft ein Verfahren zur metallischen Beschichtung der Oberfläche von Hochtemperatur - Supraleitern mit einer Kupfer - Sauerstoff Grundstruktur.

Hochtemperatur = Supraleiter (HTSL) eignen sich auf Grund ihrer überlegenen technischen Eigenschaften als elektrische Betriebsmittel in der Energietechnik. Die verwendeten Supraleiter in Form der $Bi_2Sr_2CaCu_2O_{8+x}$ (Bi2212) bzw. $Bi_2Sr_2Ca_2Cu_3O_{10+y}$ (Bi2223) oder $Y_1Ba_2Cu_3O_{7-\delta}$ (Y123)- Verbindungen benötigen für den Einsatz elektrische oder thermische Kontakte, elektrische oder thermische Shunts oder Oberflächenschichten zur Passivierung und Stabilisierung. Obgleich der Y123 - HTS gegenüber den anderen Verbindungen exzellente physikalische Eigenschaften besitzt, ist es bisher nicht gelungen, große Leiterlängen herzustellen. Dagegen werden der Bi - Supraleiter schon in km -Einheiten produziert. Die notwendige Ag - Matrix in den Bi2212 Drähten verhindert allerdings einige interessante Anwendungen, so den direkten Einsatz für Stromzuführungen oder Strombegrenzer. Durch die hohe elektrische und Wärmeleitfähigkeit des Silbers wird der gewünschte reduzierte Wärmeübergang in einen Tieftemperaturkryostaten ungewollt vergrößert ( Stromzuführung). Der schnelle Aufbau eines möglichst hohen Widerstandes zur Begrenzung eines elektrischen Kurzschlusses in einem HTS - Strombegrenzer wird durch die Ag - Matrix gleichermaßen behindert. Einen Ausweg bieten Legierungen AgAu/Ag bzw. Ag/AgMg, die in Kombination mit den Bi - HTS eine geringere elektrische Leitfähigkeit und einen kleineren Koeffizienten der

Wärmeleitfähigkeit gegenüber metallischem Ag aufweisen. Nachteilig an diesen Leiter - Technologien ist der hohe Kostenfaktor durch die notwendige Silber -Matrix.

Aus der Patentschrift DE-C2 42 20 925 ist ein pulvermetallurgisches Verfahren zur Herstellung von elektrischen Kontakten auf HTS Material bekannt, bei dem die Kontakte kalt - isostatisch verpresst und anschließend gesintert werden. Als zu verpressende Pulver kommen HTS -Material oder nicht - supraleitende Vorprodukte zur Anwendung. Weiterhin ist nach der DE -A1 44 18 050 ein Verfahren zur induktiven Begrenzung von Kurzschlußströmen mittels supraleitender Hohlzylinder bekannt, bei dem lokale Überhitzungen, sogenannte "hot spots", durch Metallschichten mit einem spezifischen Widerstand > 1 $\mu\Omega$cm bei 77 K, insbesondere metallische Leiter aus Blei, Antimon, Indium, Wismut, Stahl, Zinn oder Zink oder deren Legierungen überbrückt werden. Die Ausführungen beschreiben ein HTS -Rohr mit armiertem Metallshunt zur Strombegrenzung in einer Strombegrenzerschaltung. Die entscheidende physikalische Größe für die Shuntfunktion ist die Qualität der elektrische Kontaktierung der Metallschichten auf dem keramischen Supraleiter. Durch die zur Anwendung kommenden Metalle und Legierungen, die bis auf Wismut nicht Bestandteile der neuen HTS sind, werden relativ hohe Übergangswiderstände erreicht, die unedlen Metalle oxidieren und die Stabilität der Metall - HTS Verbindung wird negativ beeinflußt. Langzeit - Degradationen sind bei diesen Lösungen vorprogrammiert. Die Kombination von massiven Bi2212 HTS mit metallischen Leitern, vorzugsweise aus Edelmetallen wie Ag, Au, Ru, Os, Rh, Ir, Pd oder Pt wird in der DE - A1 41 24 980 beschrieben. In die dort in einem Schleudergußverfahren nach DE -OS 38 30 092 hergestellten Bi2212 Rohre werden während des Prozesses metallische Leiter, z.B. Silber - Drähte über die ganze Länge oder an den Enden eingeschmolzen. Diese dienen der Stabilisierung des Supraleiters und der Zuführung von Strom über die Endkontakte. Das in -situ Verfahren ist aufwendig und führt nicht selten zur Zerstörung eines homogenen Supraleiter - Gefüges. Die Entstehung von nicht supraleitenden Fremdphasen ist bei Temperaturen bis 870 ° C nicht auszuschließen.

Die Aufgabe der Erfindung besteht deshalb in der Schaffung eines Verfahrens zur metallischen Beschichtung der Oberfläche von Hochtemperatur - Supraleitern mit einer Kupfer - Sauerstoff Grundstruktur, das einen geringeren Herstellungsaufwand erfordert, zur Schaffung von Kontakten mit einem geringeren elektrischen und/ oder thermischen Übergangswiderstand dient, sowie die Stabilität der Metallisierung vergrößert. Gelöst wird diese Aufgabe durch die Merkmale des Patentanspruches 1. Vorteilhafte Weiterbildungen des erfindungsgemäßen Verfahrens werden durch die Merkmale der Patentansprüche 2 bis 10 beschrieben.

Nachfolgend soll das erfindungsgemäße Verfahren anhand eines Ausführungsbeispieles näher erläutert werden. In der Zeichnung zeigt

**Fig. 1** :   die schematische Darstellung der Beschichtungseinrichtung für HTS,

**Fig. 2** :   einen mäanderförmig beschichteten Supraleiter zur Begrenzung elektrischer Kurzschlußströme,

**Fig. 3 :**   die funktionelle Abhängigkeit der Reaktionszeit (Quenchzeit) des Supraleiters von der kritischen Stromdichte und

**Fig. 4** :   die schematische Zusammenfügung von Supraleitern mittels Metallschichten.

Nachfolgend wird das erfindungsgemäße Verfahren zum Aufbringen metallischer Schichten aus Kupfer bzw. Kupfer - Legierungen auf Hochtemperatur- Supraleitern beschrieben. Die Besonderheit der hier beanspruchten Abscheidung wie sie im Patentanspruch 1 definiert ist, liegt in der Einmaligkeit und Unverwechselbarkeit des Elementes Kupfer als chemischer und struktureller Träger aller neu entdeckten HTS. Durch die chemische- physikalische Affinität von Schichten und Strukturen aus Cu bzw. Cu - Legierungen auf Oberflächen und Grenzflächen der neuen Kuprat - Supraleiter entstehen feste Metall - HTS - Verbindungen als Komposite, insbesondere mit der angestrebten Langzeitstabilität. Das Verfahren dient zur Abscheidung von metallischem Kupfer auf Hochtemperatur - Supraleitermaterial zur Herstellung von elektrischen, thermischen oder optischen Kontakten. Erfindungsgemäßes Ziel war die Ablösung der bisherigen kosten- und zeitaufwendigen Kontaktierungs- und Beschichtungsverfahren durch eine einfache und wirtschaftliche Variante. Überraschenderweise läßt sich die galvanische Abscheidung auf die keramischen Supraleitermaterialien anwenden. Voraussetzung ist dafür eine ausreichende elektrische Leitfähigkeit des Materials bei Raumtemperatur. Für die praktische Anwendung der neuen Supraleiter werden durch eine Beschichtung des Supraleiters wesentliche Eigenschaften und Materialparameter verbessert oder erst dadurch möglich. Der Vorteil der Erfindung der galvanischen Beschichtung von HTS in Form von massiven schmelztexturierten Körper, Dünn- oder Dickschichten, Drähten und Bändern mit Cu bzw. Cu- Legierungen löst die o. g. Aufgabenstellung. Das Verfahren bewirkt,

(1) daß die Oberflächen der HTS Materialien gegen chemische und mechanische Angriffe versiegelt werden (Funktion der Passivierung)
(2) daß unter hohen elektrischen Belastungen die Strom- und Spannungsstabilität der Supraleiter verbessert wird
(3) daß eine Verfestigung des HTS -Materials mit Steigerung der Härte durch Auffüllen von Mikrorissen und Poren und von der Oberfläche her erzielt wird
(4) daß eine metallische Zwischenschicht die Haft- und Kontaktfähigkeit weiterer Schichten insbesondere aus Edelmetallen wie Ag, Au, Pt, Ir, Rh, Ru, Os, Pd, W, und Ni, Cr, Re, sowie deren Legierungen verbessert
(5) daß die metallische Schicht die thermodynamische Ankopplung des Supraleiters an Kältequellen verbessert
(6) daß die Rauhigkeit der Oberflächen der HTS eingeebnet und/oder für optische Zwecke feinpoliert wird
(7) daß lötfähige Kontakte entstehen, mit denen Anschlüsse an die HTS angebracht bzw. die HTS - Komponenten miteinander verbunden werden
(8) daß durch die Metallisierung die Press- und Klemmkontakte auf den HTS entstehen
(9) daß galvanische Schichten auf polykristallinen HTS für Transportströme die resistive Komponente verringern und an den Korngrenzen durch ein Vorbeikommutieren des Stromes die elektrische Stabilität verbessern

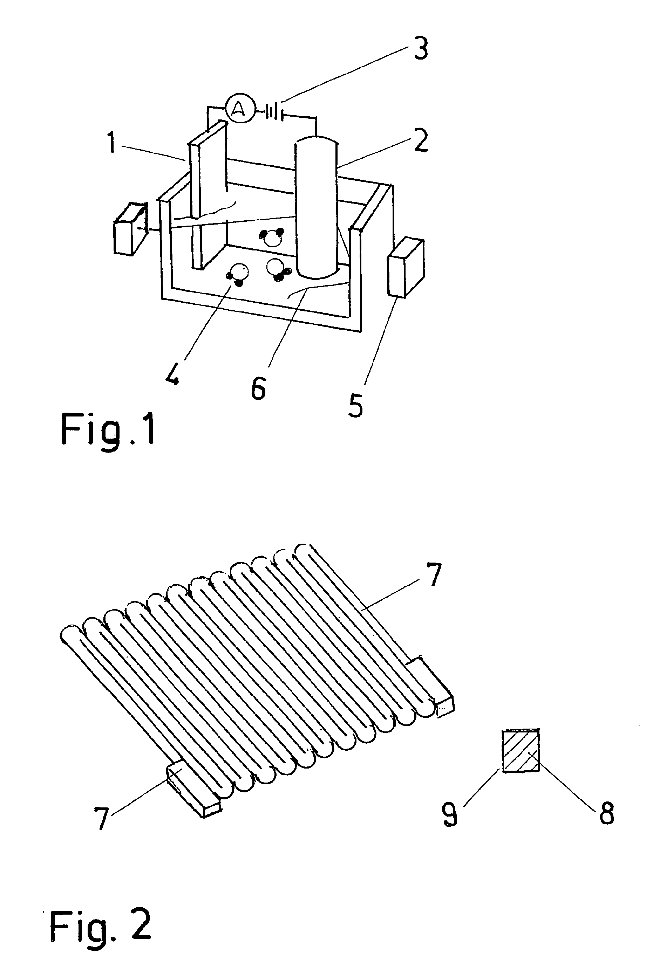

Mit dem vorliegendem erfindungsgemäßen Verfahren wird gezeigt, daß die Beschichtung der Hochtemperatur - Supraleiter mit Kupfer bzw. Legierungen des Kupfers die Beständigkeit der Supraleiter gegenüber elektrischen Lasten, insbesondere wechselnden Belastungen wie Kurzschlüssen und Überspannung, mechanischen Belastungen, chemischen Angriffen oder die Stabilität bei Ausfall der Kühlung deutlich verbessert.
Nach Figur 1 treibt zwischen Anode1 und Kathode 2 eine regelbare Gleichstromquelle 3 den elektrolytischen Prozeß in einer galvanische Zelle Die elektrolytische Abscheidung von Kupfer auf Hochtemperatur - Supraleitermaterial gelingt am effektivsten mit hoher Stromdichte bei Verwendung eines schwefelsauren Elektrolyten 4. Die Abscheidung ist auch über alkalische Zyanidelektrolyte möglich.
Die Abscheidung von Cu - Legierungen auf HTS ist erfindungsgemäß einmal dadurch möglich, daß durch die Wahl der Ionenkonzentration der Elektrolyte der Strompotentialkurven der einzelnen Legierungskomponenten so zusammengeschoben werden, daß ein gemeinsames Abscheidepotential erreicht wird.
Das erfindungsgemäße galvanische Abscheiden wird zusätzlich mit Vorrichtungen zur Homogenisierung und Kornverfeinerung der Schichten gekoppelt:

(a) Ultraschallerregung des Elektrolyten
(b) Überlagerung von Magnetfeldern
(c) Takten des Gleichstromes

in Kombination oder einzelnen Schritten.
Gemäß der Erfindung werden auf Supraleitermaterial folgende Kupfer - Legierungen abgeschieden:

Kupfer - Zink (Messing); ein Verhältnis von 1: 1 im Elektrolyten liefert Schichten der Zusammensetzung Cu : Zn = 70 : 30
Kupfer - Zinn (Zinnbronze)
Kupfer - Aluminium (Aluminiumbronze)
Kupfer - Nickel (Monel)
Kupfer - Beryllium (Berylliumbronze - hohe Festigkeit)

Berücksichtigt werden muß außerdem die chemische Polarisation, die die galvanische Abscheidung mehrerer Komponenten befördern oder im ungünstigen Fall vollständig verhindern kann.

Die elektrolytischen Lösungen werden im Bad dauernd oder periodisch gefiltert, um Verunreinigungen, vor allem Reaktionsprodukte mit der empfindlichen HTS -Oberfläche bei zu hohen Stromdichten zu entfernen.

Die Stromquelle ist erfindungsgemäß so ausgelegt, dass der fließende Strom konstant oder in einem weiten Verhältnis von Durchlaß und Sperrzeit gepulst werden kann. Die Periode des Stromflusses ist dabei variabel von 0,001 Hz bis 1 kHz. Durch die Pulsung läßt der Elektrolyt höhere Stromdichten zu. Die Schichten werden feinkörniger und mechanisch stabiler.

In einer weiteren Auskhrungsform wird an die galvanische Zelle in der Nähe der Anode und /oder der Kathode durch eine Magnetvorrichtung 5 ein magnetisches Feld 6 angelegt. Die resultierenden Lorentzkräfte $F = Cu^{2+}/ Me^{2+} ( v \times B )$, v - Geschwindigkeit der geladenen Ionen, B- Magnetfeld, erzeugen eine Ablenkung der Cu - Ionen verbunden mit einer Badbewegung und einem resultierenden gleichmäßigen und feinkörnigen Schichtaufbau. In Tabelle I sind die physikalischen Eigenschaften von Kupfer - Legierungen und Hochtemperatur - Supraleitern verglichen.

Tabelle I : Vergleich des spezifischen elektrischen Widerstandes verschiedener Cu - Verbindungen mit Bi - und Y123 - HTS

| | $\rho$ (77K) [$\mu\Omega$cm] | $\rho$ (100 K) [$\mu\Omega$cm] | $\rho$ ( 293 K) [$\mu\Omega$cm] |
|---|---|---|---|
| $Bi_2Sr_2CaCu_2O_{8+y}$ | | 800 | 1200 |
| $Y_1Ba_2Cu_3O_{7-\delta}$ | | 1000 | 1500 |
| Kupfer, metallisch | 0.2 | 0.4 | 1.6 |
| Messing 80/20 | 3.8 | 4.3 | 6.8 |
| Messing 70/30 | 4.6 | 4.9 | 6.8 |
| CuNi 70 /30 | 36.5 | 37 | 38 |
| CuNiMn 54/45/1 | 32 | 33 | 35 |
| CuAl | | | 11,4 |
| CuSn 3 | 9.6 | 9.7 | 10.1 |

Ferner besteht die Möglichkeit der elektrischen Homogenisierung und Stabilisierung von HTS durch Kupfer -Nickellegierungenin Form der Shuntfunktion in supraleitenden Strombegrenzern. Dadurch soll die Funktion der Strombegrenzung mittels eines hohen spezifischen elektrischen Widerstandes der Schicht erreicht werden. Die Abscheidung von Kupfer - Nickel - Legierungen auf Oberflächen von Hochtemperatur- Supraleitern wird über phosphathaltige saure oder alkalische Zyanidelektrolyte vorgenommen. Die Zusammensetzung für die Abscheidung von Kupferlegierungen mit bis zu 50 % Ni auf HTS erfolgt über einen Elektrolyten der Zusammensetzung:

| | |
|---|---|
| Kupferpyrophosphat $Cu_2P_2O_7$ | 5 -10 g/l |
| Nckelchlorid $NiCl_2$ x 6 $H_2O$ | 40 - 90 g/l |
| Kaliumpyrophosphat oder Natrium-Pyrophosphat $(K / Na)_4P_2O_7$ x 10 $H_2O$ | 300 - 400 g/l |

Die Figur 2 zeigt eine mögliche Form eines beschichteten YBCO - HTS Mäander- Moduls 7 für die resistive schnelle Begrenzung von Kurzschlußströmen in Energieversorgungsanlagen.

Beim Einsatz des Supraleiters zur schnellen Begrenzung eines elektrischen Kurzschlußstromes bedient man sich ausgehend vom supraleitenden Zustand eines Leiterstückes aus HTS mit einem Leiterquerschnitt 8des schnellen Aufbaus der Normalleitung bei Überschreiten einer bestimmten kritischen Stromdichte. Da der Begrenzervorgang nicht getriggert werden muß, sondern allein durch den Kurzschlußstrom intrinsisch ausgelöst wird, gehören supraleitende Strombegrenzer zu den potentiellen Anwendungen für energietechnische Betriebsmittel. Bei diesem resistiven Strombegrenzertyp entsteht nach dem supraleitend - normaleitenden Übergang durch den Kurzschlußstrom schlagartig Joulsche Wärme, die der Supraleiter tragen muß. Die Auslegung des supraleitenden Strombegrenzers richtet sich nach den elektrischen Größen Strom und Spannung, die den limitierenden Widerstand ohne Shunt $R_1$ und mit Beschichtungs-Shunt $R_1^B$ gegeben durch die Länge des Supraleiters 1 bestimmen.

$$R_1 = \rho\ l/A \qquad\qquad \text{ohne Beschichtung}$$

$$R_l{}^B = (\rho_{sl} + \rho_m)\, l\, /\, (A_{sl} + A_m) \qquad \text{mit Beschichtung}$$

$\rho_{s1}$ und $\rho_m$ bzw. $A_{s1}$ und $A_m$ sind die zugehörigen spezifischen Widerstände bzw. Leiterquerschnitte für den Supraleiter und den metallischen Shunt.

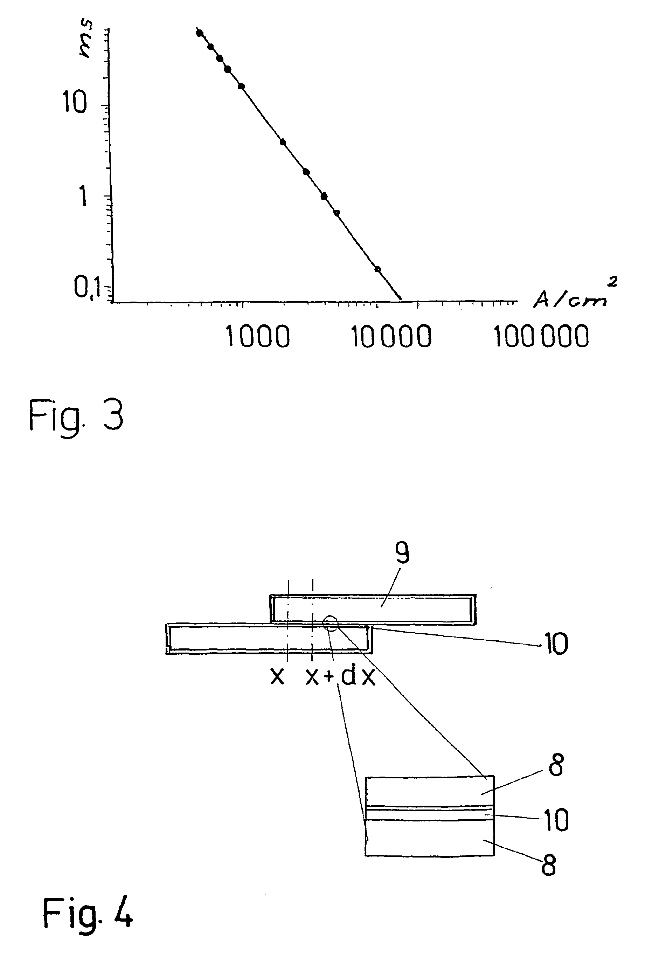

Dieses Verhalten ist allen Typen von resistiven Begrenzern auf Supraleiterbasis gemeinsam. Dabei spielt die Vermeidung von sogenannten "hot spots" im Supraleiter eine entscheidende Rolle bei der technischen Realisierung. Die metallische Beschichtung mit einer hochresistiven Schicht einer Kupferlegierung 9, im besonderen CuNi, verbessert die Homogenität und Stabilität des supraleitenden Materials in seiner Funktion als selbsttätig strombegrenzendes Element im Falle eines Kurzschlusses. Da im Quenchfall der spezifische Widerstand des HTS Leiters wesentlich größer ist als derjenige der metallischen Beschichtung, wird der Strom hauptsächlich durch den Shunt fließen und den Supraleiter schützen. Die Dimensionierung eines massiven Moduls aus YBCO zur Begrenzung eines elektrischen Kurzschlusses ist so ausgelegt, daß ein elektrischer Strom von 2000 Ampere ungehindert fließen kann. Im Falle eines Kurzschlusses steigt der Strom auf ein Vielfaches des Nennstromes. Der Supraleiter mit einer kritischen Transportstromdichte von etwa 10 kA/cm$^2$ begrenzt durch seinenbeispielsweisen geometrische Leiterquerschnitt von 6 x 8 mm$^2$ = 0.48 cm$^2$ den Strom bei etwa 5 kA. Für eine 10 kV Spannungsversorgung werden zum Aufbau des Begrenzerwiderstandes sechzehn in Reihe geschaltete YBCO Module zu je 4.8 m Länge benötigt. Das Begrenzungsverhalten eines supaleitenden Strombegrenzers hängt wie in Fig. 3 dargestellt wesentlich von der kritischen Stromdichte $J_c$, von der Ausführung der Supraleiter - Metall - Kombination (Verhältnis der Querschnitte) und von der Länge des Leiters ab. Für eine Ansprechzeit des Strombegrenzers von beispielsweise 1 ms ist somit grundsätzlich eine kritische Stromdichte von etwa 4 kA/cm$^2$ notwendig. Ein sehr langer Leiter begrenzt einen Kurzschlußstrom durch den sogenannten "flux flow" - Widerstand bei elektrischen Feldstärken von 1 - 10 V/m, d.h. für eine 10 kV Netzbegrenzung werden Leiterlängen > 1000 m erforderlich. Die dissipierte Energie E J bleibt in diesem Fall klein. Durch die großen erforderlichen Leiterlängen steigen die Kosten in dieser Ausführung. Wirtschaftlich attraktiver ist ein resistiver Strombegrenzer mit kürzerer Leiterlänge, wobei Feldstärken im Begrenzungsfall von 100 - 300 V /m entstehen. Als Begrenzungswiderstand wirkt der Materialwiderstand oberhalb der kritischen Temperatur des Supraleiters (typische 100 K bei YBCO). Die Auslegungsvariante ist wirtschaftlich attraktiv, erfordert aber eine gleichmäßige Verteilung der elektrischen Begrenzungslast im Quenchfall auf den gesamten Supraleiter und mithin eine große Homogenität der elektrischen Parameter über die Länge. Zusätzlich stellt die maximal zulässige Erwärmung eine untere Grenze für das eingesetzte Supraleitervolumen dar. Der erfindungsgemäße Vorteil der galvanischen CuNi - Beschichtung ist eine Verbesserung der Leiterhomogenität, die Verminderung von hot - spot Effekten, eine höhere Strombelastung des Begrenzermoduls und ein verkleinertes Verhältnis von Begrenzerstrom zu Normalstrom. Ein weiterer positiver Effekt der Abscheidung von CuNi Schichten auf HTS besteht in der Stabilisierung von HTS - Stromzuführungen. Dabei wird die Wärmeleitfähigkeit der Schicht verringert. Supraleitende Stromzuführungen wie in Fig.4 dargestellt, erfüllen die Aufgabe, die Zuführung von Gleich- oder Wechselstrom von Raumtemperatur in ein tiefer liegendes Temperaturniveau mit einem minimalen Wärmeeintrag zu verbinden. Der Supraleiter entkoppelt dabei das für Metalle geltende Wiedemann- Franz - Gesetz, wonach ein guter elektrischer Leiter immer auch ein guter Wärmeleiter ist. Die Shuntfunktion ist Stand der Technik nach einer Reihe von Patenten und Veröffent-lichungen (DE 44 30 408 A1, DE 197 29 987 Cl, US 5,432,297). Über die konkrete Ausführung des Metallshuntes werden nur unzureichende Ausführungen wiedergegeben. Die Qualität und Wirksamkeit des Shunts hängt wesentlich vom Materialkoeffzienten der Wärmeleitfähigkeit ab, um den Wärmeeintrag in das Tieftemperaturreservoir nicht unnötig durch den Shunt zu erhöhen. Eine Verringerung der Wärmeleitung gegenüber den hohen Werten von Silber ist so durch AgAu/Ag - Legierungen gelungen. Silber und vor allem Gold sind aber kostenintensive Edelmetalle. Beim Einsatz der HTS zum Stromtransport in supraleitenden Stromzuführungen kann eine metallische Beschichtung eines YBCO - Stabes mit einer Kupfer - Legierung mit kleinem Wärme1eitungskoeffizienten in der Funktion als Shunt - Element die Stabilität und den Ausfall zumindest für eine Übergangszeit bis zur Stromabschaltung absichern. Gelöst wird die Aufgabe mit einer CuNi 80/20 - Legierung mit einem Koeffizenten der Wärmeleitfähigkeit von etwa 0.1 W/cm K bei 77 K . Die elektrischen Kontakte und die Zuleitungen werden vorzugsweise aus Kupfer ausgeführt. Der Kontaktbereich enthält eine metallische Kupferschicht - ebenfalls galvanisch aufgetragen - auf der Oberfläche. Eine hohe Festigkeit der Metallschicht wird dadurch erhalten, daß das Cu in die Mikrorisse und Poren eindringt. Die Beschichtung des restlichen stabförmigen Supraleiters mit einer Kupfer - Legierung als Rohr oder massivem Block erfolgt mittels eines citrathaltigen Elektrolyten der Zusammensetzung

| | |
|---|---|
| Kupfersulfat $CuSO_4$ x 5 $H_2O$ | 5 - 20 g/l |
| Nickelsulfat $NiSO_4$ x 7 $H_2O$ | 30 - 100 g/l |
| Zitronensäure $C_6H_8O_7$ x $H_2O$ | 80 - 100 g/l |

(fortgesetzt)

| Natriumchlorid NaCl | 3 - 5 g/l |
|---|---|

In der erfindungsgemäße Ausführung des galvanischen Verfahrens kann die Gleichstromquelle konstant oder gepulst die Beschichtung mit der CuNi -Legierung steuern. Abhängig von der Morphologie der Supraleiter - Oberfläche wird durch Anlegen von magnetischen Feldern die Homogenität der CuNi - Schichten verbessert. Die Anwendung o. g. Elektrolyte sind sicherheitstechnisch und hinsichtlich der Umweltbelastung weniger bedenklich als eine Abscheidung . über zyanidische Elektrolyte. Die Abscheidung von Kupfer - Nickel - Legierungen auf Oberflächen von Hochtemperatur-Supraleitern gelingt auch über eine alkalische Zyanidlösung der Zusammensetzung

| Natriumcarbonat $Na_2CO_3 x10H_2O$ | 20-30 g/l |
|---|---|
| Natriumbisulfit $Na_2SO_3 x9H_2O$ | 20-30 g/l |
| Kupferacetat | 20 g/l |
| Kaliumzyanid KCN | 20 g/l |

Ferner kann eine verbesserte mechanische Stabilisierung des Supraleiters beispielsweise durch die Abscheidung von Messing und CuNi auf die Oberfläche von HTS erreicht werden. Durch die Anwendung und Mischung von 0.1 normaler Kupferzyanid- und 0.1 normaler Zinkzyanidlösung liegen die Strompotentiaikurven von Kupfer und Zink bei Stromdichten von 0.1 - 0.3 A/dm$^2$ nur 0.2 V auseinander. Damit gelingt die Abscheidung einer homogenen Messing - Legierung auf HTS - Flächen. In einer Ausführungsform, dem s.g. galvanothermischen Verfahren werden Kupfer und Zinkschichten nacheinander getrennt aufgetragen und nachfolgend bei Temperaturen von 300 bis 600° C zu Messing legiert. Alternativ werden Cu /CuNi - Schichten galvanisch auf. Supraleiter -Oberflächen abgeschieden und dadurch eine bessere mechanische Stabilität erhalten.
Die Messing- und CuNi - Beschichtung verbessert die mechanische Stabilität von Supraleiter - Elementen durch Eindringen in die Mikrorisse und Poren. Die so stabilisierten HTS sind lötfähig, die Zugfestigkeit des Supraleitermaterials wird erhöht und in einer Montagetechnologie, wie in Figur 4 dargestellt, werden vorgefertigte Einzelsupraleiter 8 zu größeren Einheiten und geometrischen Formen zusammengefügt. Nach der Auftragung von Cu bzw. Cu - Legierungen 10 auf der Oberfläche der Einzelsupraleiter 8 wird die Lötschicht zwischen diesen aufgebracht.

| Kupferzyanid $Cu(CN_2)$ | 30 g/l |
|---|---|
| Zinkzyanid $Zn(Cn_2)$ | 6-10 g/l |
| NaCN | 40 g/l |
| $Na_2CO3$ | 15 g/l |

Bezugszeichen

| 1 | Anode |
|---|---|
| 2 | Kathode |
| 3 | Gleichstromquelle |
| 4 | Schwefelsaurer Elektrolyt |
| 5 | Magnetvorrichtung |
| 6 | Magnetisches Feld |
| 7 | HTS - Modul |
| 8 | Supraleiter |
| 9 | Kupferlegierung |
| 10 | Kupferlegierung |

**Patentansprüche**

1. Verfahren zur metallischen Beschichtung von Hochtemperatur - Supraleitern (HTSL) mit einer Kupfer-Sauerstoff Grundstruktur, insbesondere der RE Supraleiter (RE=Y, Nd, Sm, Yb) in stöchiometrischer und nichtstöchiometrischer Zusammensetzung und der Wismut HTSL mittels eines galvanischen Verfahrens,

**EP 1 313 895 B1**

**dadurch gekennzeichnet,**
**dass** zur Erzeugung niederohmiger Kontakte und der damit verbundenen Erreichung eines geringeren elektrischen und / oder thermischen Übergangswiderstandes sowie einer stabilen Metallisierung zwischen dem HTSL und der elektrischen und/ oder thermischen Kupplung Kupfer und/oder Kupferlegierungen mittels wässriger Kupfer-Sulfat-Elektrolyten aufgetragen werden.

2. Verfahren nach Patentanspruch 1, **dadurch gekennzeichnet, dass** auf der Oberfläche des HTSL frei oder teilweise abgedeckt gesteuert Kupfer-Strukturen erzeugt werden.

3. Verfahren nach den Patentansprüchen 1 und 2, **dadurch gekennzeichnet, dass** die Kupfer-Strukturen auf der Oberfläche des in Form von Dünn- und/ oder Dickschichten ausgebildeten HTSL gesteuert erzeugt werden.

4. Verfahren nach den Patentansprüchen 1 und 2, **dadurch gekennzeichnet, dass** die Kupfer-Strukturen auf der Oberfläche des in Form von Drähten und/ oder Bändern ausgebildeten HTSL gesteuert erzeugt werden.

5. Verfahren nach Patentanspruch 1, **dadurch gekennzeichnet, dass** ein zur Anwendung kommendes Kupfersulfat - Bad ultraschallerregt wird und **dadurch** eine härtesteigemde Wirkung auf die Kupfer-Schicht entsteht und die Tiefenselektivität verringert wird.

6. Verfahren nach Patentanspruch 1, **dadurch gekennzeichnet, dass** das Kupfer-Sulfat-Galvanisierverfahren durch Pulsung des Stromflusses mit einer Stromdichte im Bereich von 200 bis 500 mA/ cm$^2$ durchgeführt wird.

7. Verfahren nach Patentanspruch 1, **dadurch gekennzeichnet, dass** die Konzentration der zur Anwendung kommenden Lösung im Bereich von bis 250 g/l liegt.

8. Verfahren nach Patentanspruch 1, **dadurch gekennzeichnet, dass** der galvanischen Zelle ein permanentes und/ oder wechselndes Magnetfeld überlagert wird.

9. Verfahren nach Patentanspruch 1, **dadurch gekennzeichnet, dass** die galvanisch aufgetragene Schicht einer Kupferlegierung als haftverstärkende Zwischenschicht für weitere galvanische Metallschichten, insbesondere mit den Edelmetallen Ag, Au, Pt, Ir, Ru, Re, Pd, Os, W und der Metalle Ni, Cr, Mo und V dient.

10. Verfahren nach Patentanspruch 1, **dadurch gekennzeichnet, dass** die aufgebrachten Metallschichten durch chemische und/ oder thermische Verfahren in stabile Oxide gewandelt werden.

11. Verfahren nach Patentanspruch 1, **dadurch gekennzeichnet, dass** durch die thermische Behandlung von Cu/ Cu - Legierungsschichten bei einer Temperatur von ca. 80 -100 °C ein stabiles Oxid der Form $Cu_2O$ erzeugt wird.

**Claims**

1. A method for metal-coating high-temperature superconductors (HTSC) with a copper-oxygen basic structure, especially RE superconductors (RE = Y, Nd, Sm, Yb) in stoichiometric or non-stoichiometric composition and bismuth HTSC by means of an electroplating method, **characterized in that** copper and/or copper alloys are applied by means of hydrous copper-sulfate electrolytes for producing low-resistance contacts and the thus resulting achievement of a lower electric and/or thermal contact resistance and a stable metallization between the HTSC and the electric and/or thermal coupling.

2. A method according to claim 1, **characterized in that** copper structures are produced on the surface of the HTSC in a free or partly covered and controlled manner.

3. A method according to claims 1 and 2, **characterized in that** the copper structures are produced in a controlled manner on the surface of the HTSC arranged in the form of thin and/or thick layers.

4. A method according to the claims 1 and 2, **characterized in that** the copper structures are produced in a controlled manner on the surface of the HTSC arranged in the form of wires and/or strips.

5. A method according to claim 1, **characterized in that** an applied copper sulfate bath is excited by ultrasonic sound and as a result a hardness-increasing effect on the copper layer is obtained and the depth selectivity is reduced.

**6.** A method according to claim 1, **characterized in that** the copper-sulfate electroplating method is carried by pulsing the current flow with a current density in the range of 200 to 500 mA/cm$^2$.

**7.** A method according to claim 1, **characterized in that** the concentration of the applied solution lies in the range of up to 250 g/l.

**8.** A method according to claim 1, **characterized in that** the electroplating cell is superimposed with a permanent and/or alternating magnetic field.

**9.** A method according to claim 1, **characterized in that** the electroplated layer is used for a copper alloy as a bond-strengthening intermediate layer for further electroplated metallic layers, especially with the precious metals Ag, Au, Pt, Ir, Ru, Re, Pd, Os, W and the metals Ni, Cr, Mo and V.

**10.** A method according to claim 1, **characterized in that** the applied metal layers are converted by chemical and/or thermal processes into stable oxides.

**11.** A method according to claim 1, **characterized in that** a stable oxide in the form of $Cu_2O$ is produced by thermal treatment of Cu/Cu alloy layers at a temperature of approximately 80 to 100°C.

**Revendications**

**1.** Procédé de métallisation de supraconducteurs à haute température (SCHT) ayant une structure de base cuivre-oxygène, notamment de supraconducteurs RE (RE = Y, Nd, Sm, Yb), dans une composition stoechiométrique et non stoechiométrique et de SCHT bismuth moyennant un procédé galvanique,
**caractérisé en ce**
**que**, pour obtenir des contacts à faible résistance et la résistance de transition électrique et/ou thermique moins importante qui en découle, ainsi qu'une métallisation stable entre le SCHT et la connexion électrique et/ou thermique, on applique du cuivre et/ou des alliages cuivreux moyennant des électrolytes aqueux à base de sulfate de cuivre.

**2.** Procédé selon la revendication 1, **caractérisé en ce que** l'on produit de façon contrôlée des structures de cuivre sur la surface du SCHT exposée ou en partie recouverte.

**3.** Procédé selon les revendications 1 et 2, **caractérisé en ce que** l'on produit de façon contrôlée les structures de cuivre sur la surface du SCHT réalisé sous forme de couches minces et/ou épaisses.

**4.** Procédé selon les revendications 1 et 2, **caractérisé en ce que** l'on produit de façon contrôlée les structures de cuivre sur la surface du SCHT réalisé sous forme de fils et/ou de bandes.

**5.** Procédé selon la revendication 1, **caractérisé en ce qu'**un bain de sulfate de cuivre utilisé est excité par ultrasons ce qui permet d'obtenir un effet augmentant la dureté de la couche de cuivre et de réduire la sélectivité en profondeur.

**6.** Procédé selon la revendication 1, **caractérisé en ce que** le procédé galvanique sulfate de cuivre est effectué envoyant le flux de courant par impulsions à une densité de courant comprise entre 200 et 500 mA/cm$^2$.

**7.** Procédé selon la revendication 1, **caractérisé en ce que** la concentration de la solution utilisée est de l'ordre de 250 g/l maximum.

**8.** Procédé selon la revendication 1, **caractérisé en ce que** l'on superpose à la cellule galvanique un champ magnétique permanent et/ou alternatif.

**9.** Procédé selon la revendication 1, **caractérisé en ce que** la couche d'un alliage cuivreux appliquée par électrolyse sert de couche intermédiaire augmentant l'adhésion de couches galvaniques métalliques supplémentaires, notamment de couches contenant les métaux précieux Ag, Au, Pt, Ir, Ru, Re, Pd, Os, W et les métaux Ni, Cr, Mo et V.

**10.** Procédé selon la revendication 1, **caractérisé en ce que** les couches de métal appliquées par des procédés chimiques et/ou thermiques sont transformées en oxydes stables.

**11.** Procédé selon la revendication 1, **caractérisé en ce que** l'on obtient un oxyde stable de forme $Cu_2O$ en traitant thermiquement des couches d'alliage Cu/Cu à une température comprise entre environ 80 et 100 C.

Fig.1

Fig. 2

Fig. 3

Fig. 4